(19) Europäisches Patentamt / European Patent Office / Office européen des brevets

(11) **EP 3 896 745 B1**

(12) **FASCICULE DE BREVET EUROPEEN**

(45) Date de publication et mention
de la délivrance du brevet:
**15.02.2023 Bulletin 2023/07**

(21) Numéro de dépôt: **21166382.8**

(22) Date de dépôt: **31.03.2021**

(51) Classification Internationale des Brevets (IPC):
*H01L 29/872* (1995.01)   *H01L 21/329* (1990.01)
*H01L 29/06* (1974.07)   *H01L 29/20* (1974.07)
*H01L 29/417* (1995.01)   *H01L 29/16* (1974.07)

(52) Classification Coopérative des Brevets (CPC):
**H01L 29/872; H01L 29/0619; H01L 29/0649;**
**H01L 29/0657; H01L 29/2003; H01L 29/417;**
**H01L 29/66212;** H01L 29/1608

(54) **DIODE SCHOTTKY À BARRIÈRE DE JONCTION**

ÜBERGANGSBARRIERE-SCHOTTKY-DIODE

JUNCTION BARRIER SCHOTTKY DIODE

(84) Etats contractants désignés:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priorité: **16.04.2020 FR 2003847**

(43) Date de publication de la demande:
**20.10.2021 Bulletin 2021/42**

(73) Titulaire: **Commissariat à l'Energie Atomique et**
**aux Energies**
**Alternatives**
**75015 Paris (FR)**

(72) Inventeur: **BUCKLEY, Julien**
**38054 Grenoble Cedex 9 (FR)**

(74) Mandataire: **Cabinet Camus Lebkiri**
**25 rue de Maubeuge**
**75009 Paris (FR)**

(56) Documents cités:
WO-A1-2018/146791   US-A1- 2007 210 401
US-A1- 2018 097 123   US-A1- 2019 165 187

**Description**

**DOMAINE TECHNIQUE DE L'INVENTION**

Le domaine technique de l'invention est celui de l'électronique de puissance. La présente invention concerne une diode capable de supporter des surcharges en courant et plus particulièrement une diode Schottky à barrière de jonction (JBS).

**ARRIERE-PLAN TECHNOLOGIQUE DE L'INVENTION**

Les diodes sont des composants classiques de l'électronique de puissance car elles permettent la mise en oeuvre de fonctions de base telles que la commutation, le redressement, la division de tension...

Il est particulièrement avantageux dans le domaine de l'électronique de puissance que les diodes présentent une vitesse de commutation élevée, une faible résistivité à l'état passant (c'est-à-dire un courant élevé à l'état passant) et une tension de claquage élevée. La résistivité à l'état passant et la tension de claquage d'une diode dépendent fortement du matériau semi-conducteur utilisé pour fabriquer la diode. Le nitrure de galium (GaN) est couramment employé car il présente l'un des meilleurs compromis entre résistivité à l'état passant et tension de claquage.

La diode Schottky à barrière de jonction ou « JBS » (pour « Junction-Barrier-Schottky » en anglais) est une diode mixte Schottky-bipolaire comportant une diode Schottky et une diode bipolaire (typiquement une diode PIN, pour « P-type Intrinsic N-type » en anglais) couplées en parallèle. A faible tension de polarisation directe, la diode JBS présente un comportement essentiellement Schottky caractérisé par une faible tension de seuil. A plus forte tension de polarisation directe, la diode JBS présente un comportement essentiellement bipolaire caractérisé par une diminution de la résistivité, ce qui lui permet de supporter des surcharges en courant. On parle également de diode à surcharge ou de diode « MPS » (pour « Merged PIN Schottky » en anglais) si par conception la diode exploite les modes de conduction Schottky et bipolaire.

Une diode JBS comprend typiquement une alternance de jonctions PN et de jonctions Schottky (jonctions métal-semiconducteur). Sous polarisation inverse, les zones de charge d'espace des jonctions PN vont s'étendre sous le contact Schottky et se recouvrir à partir d'une certaine tension inverse, conduisant alors à la création d'une barrière de potentiel entre cathode et anode. Cette barrière de potentiel réduit le champ électrique sous le contact Schottky et, par conséquent, le courant de fuite qui en dépend.

La diode JBS cumule ainsi les avantages de la diode Schottky en termes de tension de seuil et de vitesse de commutation et les avantages de la diode PIN en termes de courant de fuite (sous polarisation inverse) et robustesse aux surcharges en courant (sous forte polarisation directe).

Le document [« Vertical GaN junction barrier schottky diodes by Mg implantation and activation annealing », A. D. Koehler et al., 2016 IEEE 4th Workshop on Wide Bandgap Power Devices and Applications (WiPDA). IEEE, pp. 344-346, 2016] décrit un premier exemple de diode JBS GaN. Les jonctions PN sont formées par implantation de dopants de type p (typiquement des ions magnésium) dans une couche active appelée « couche de dérive » (« drift layer » en anglais) en GaN non intentionnellement dopé (UID GaN).

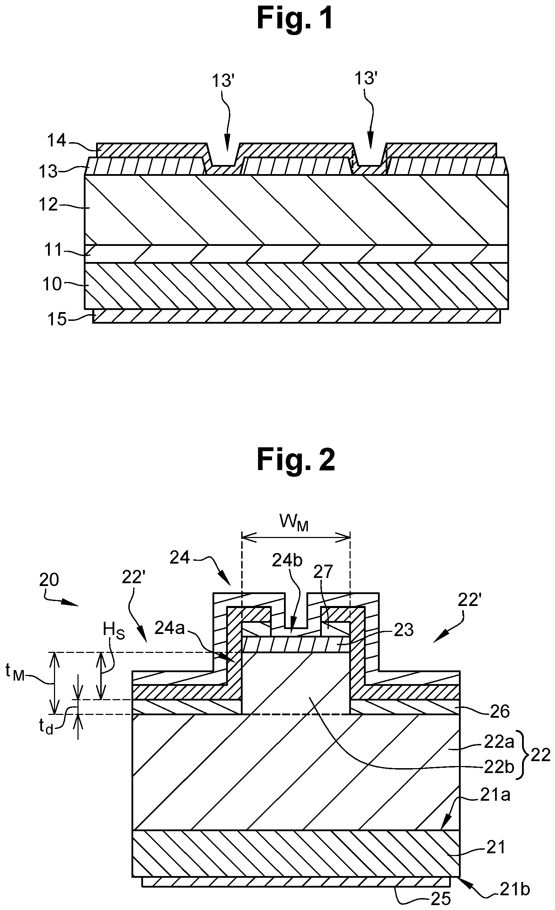

La figure 1 représente un deuxième exemple de diode JBS GaN, tel que décrit dans le document [« Design and realization of GaN trench junction-barrier-Schottky-diodes », W. Li et al., IEEE Transactions on Electron Devices, Vol. 64, No. 4, pp. 1635-1641, 2017].

La diode JBS GaN comprend :

- un substrat 10 en GaN ;

- une couche de $n^+$-GaN 11 (GaN fortement dopé de type n) disposée sur une première face du substrat 10 ;

- une couche de dérive 12 en n-GaN (GaN plus faiblement dopé de type n) disposée sur la couche de $n^+$-GaN 11 ;

- une couche de p-GaN 13 (GaN dopé de type p) disposée sur la couche de dérive 12 et dans laquelle sont formées des tranchées circulaires 13', les tranchées circulaires 13' s'étendant jusqu'à la couche de dérive 12 ;

- une anode 14 disposée sur la couche de p-GaN 13 et dans les tranchées 13', en contact ohmique avec la couche de p-GaN 13 et en contact Schottky avec la couche de dérive 12 en n-GaN ;

- une cathode 15 disposée sur une deuxième face opposée du substrat 11.

Ainsi, dans cette diode JBS à tranchées, les jonctions Schottky se situent au même niveau que les jonctions PN. Le document montre que, lorsque le diamètre des tranchées diminue (à surface de diode constante), le courant de fuite en inverse et le courant de fonctionnement nominal diminuent et le courant admissible en surcharge augmente. Le dimensionnement de la structure de diode de la figure 1 a une influence simultanée sur ces trois courants électriques. Il n'est donc pas possible de les fixer de façon indépendante.

Le document US 2018/097123 montre une diode Schottky à barrière de jonction comprenant : un substrat ; une première couche semi-conductrice, disposée sur une première face du substrat et présentant un premier type de conductivité, la première couche semi-conductrice comprenant une portion en saillie délimitée par une tranchée ; une deuxième couche semi-conductrice disposée sur la portion en saillie de la première couche semi-conductrice et présentant un deuxième type de conductivité opposé au premier type de conductivité ; une première électrode comprenant : une première portion en contact Schottky avec la première couche semi-conductrice, la première portion de la première électrode étant disposée contre une paroi latérale de la portion en saillie de la première couche semi-conductrice ; une deuxième portion en contact ohmique avec la deuxième couche semi-conductrice ; une deuxième électrode en contact ohmique avec le substrat.

## RESUME DE L'INVENTION

Il existe donc un besoin de prévoir une structure de diode Schottky à barrière de jonction (JBS) permettant d'ajuster l'un des paramètres électriques de la diode de façon indépendante.

Selon un premier aspect de l'invention, on tend à satisfaire ce besoin en prévoyant une diode Schottky à barrière de jonction (JBS) comprenant :

- un substrat ;
- une première couche semi-conductrice, disposée sur une première face du substrat et présentant un premier type de conductivité, la première couche semi-conductrice comprenant une portion en saillie délimitée par une tranchée ;
- une deuxième couche semi-conductrice disposée sur la portion en saillie de la première couche semi-conductrice et présentant un deuxième type de conductivité opposé au premier type de conductivité ;
- une couche électriquement isolante disposée au fond de la tranchée ;
- une première électrode comprenant :

    - une première portion en contact Schottky avec la première couche semi-conductrice, la première portion de la première électrode étant disposée sur la couche électriquement isolante et contre une paroi latérale de la portion en saillie de la première couche semi-conductrice ;
    - une deuxième portion en contact ohmique avec la deuxième couche semi-conductrice ;

- une deuxième électrode en contact ohmique avec le substrat.

La réalisation d'un contact Schottky latéral, plutôt que dans le plan de la jonction PN, permet de décorréler la surface de contact Schottky et la surface de jonction PN tout en minimisant le courant de fuite. Il devient alors plus facile de dimensionner la diode JBS pour atteindre les performances souhaitées. En particulier, le courant admissible en surcharge de la diode JBS (qui est caractéristique du fonctionnement bipolaire) peut être ainsi ajusté de façon indépendante du courant de fuite en inverse et du courant de fonctionnement nominal (qui sont caractéristiques du fonctionnement Schottky).

Dans un premier mode de réalisation, la deuxième électrode est disposée sur une deuxième face du substrat opposée à la première face.

Dans un deuxième mode de réalisation, la première couche semi-conductrice occupe une partie seulement de la première face du substrat et la deuxième électrode est disposée sur la première face du substrat.

Dans un troisième mode de réalisation compatible avec les deux précédents, la première couche semi-conductrice comprend une pluralité de portions en saillie délimitées chacune par une tranchée, la deuxième couche semi-conductrice est disposée sur la pluralité de portions en saillie de la première couche semi-conductrice, la première portion de la première électrode est disposée contre une paroi latérale de chaque portion en saillie de la première couche semi-conductrice et la deuxième portion de la première électrode est disposée sur chaque portion en saillie de la première couche semi-conductrice en contact avec la deuxième couche semi-conductrice.

Outre les caractéristiques qui viennent d'être évoquées dans les paragraphes précédents, la diode JBS selon le premier aspect de l'invention peut présenter une ou plusieurs caractéristiques complémentaires parmi les suivantes, considérées individuellement ou selon toutes les combinaisons techniquement possibles :

- le contact Schottky présente une hauteur (Hs) comprise entre 0,1 $\mu$m et 3 $\mu$m ;

- la couche électriquement isolante présente une épaisseur supérieure ou égale à 0,05 $\mu$m ;

- la première portion de la première électrode est formée par une couche d'un premier métal et la deuxième portion de la première électrode est formée par une couche d'un deuxième métal, distinct du premier métal ;

- le deuxième métal présente un travail de sortie supérieur au travail de sortie du premier métal ;

- le substrat comprend une couche de matériau semi-conducteur dopé du premier type de conductivité ; et

- la couche de matériau semi-conducteur du substrat présente une concentration en impuretés dopantes supérieure ou égale à $10^{17}$ cm$^{-3}$.

Un deuxième aspect de l'invention concerne un procédé de fabrication de diode Schottky à barrière de jonction. Ce procédé comprend les étapes suivantes :

- former un empilement comprenant successivement un substrat, une première couche semi-conductrice présentant un premier type de conductivité et une deuxième couche présentant un deuxième type de conductivité opposé au premier type de conductivité ;

- graver une tranchée dans la deuxième couche semi-conductrice et une partie de la première couche semi-conductrice, de manière à délimiter une portion en saillie de la première couche semi-conductrice et à limiter la deuxième couche semi-conductrice à la portion en saillie de la première couche semi-conductrice ;

- former une couche électriquement isolante au fond de la tranchée ;

- former une première électrode comprenant :

  - une première portion en contact Schottky avec la première couche semi-conductrice, la première portion de la première électrode étant disposée sur la couche électriquement isolante et contre une paroi latérale de la portion en saillie de la première couche semi-conductrice ;

  - une deuxième portion en contact ohmique avec la deuxième couche semi-conductrice ;

- former une deuxième électrode en contact ohmique avec le substrat.

De préférence, l'étape de gravure de la tranchée présente un coefficient d'isotropie supérieur à 0,3.

Dans un mode de mise en oeuvre, l'étape de formation de la couche électriquement isolante au fond de la tranchée comprend les opérations suivantes :

- former une couche de matériau diélectrique comprenant une première portion disposée au fond de la tranchée et une deuxième portion disposée contre la paroi latérale de la portion en saillie de la première couche semi-conductrice, la première portion présentant une épaisseur supérieure à celle de la deuxième portion ; et

- graver de manière isotrope la couche de matériau diélectrique de façon à retirer uniquement la deuxième portion.

Ainsi, la couche de matériau diélectrique est déposée de façon anisotrope.

Dans un mode de mise en oeuvre, l'étape de formation de la première électrode comprend les opérations suivantes :

- déposer une couche d'un premier métal sur la couche électriquement isolante, contre la paroi latérale de la portion en saillie de la première couche semi-conductrice et sur la deuxième couche semi-conductrice ;

- former dans la couche du premier métal une ouverture débouchant sur la deuxième couche semi-conductrice ;

- déposer une couche d'un deuxième métal dans l'ouverture, en contact avec la deuxième couche semi-conductrice, le deuxième métal étant distinct du premier métal.

L'invention et ses différentes applications seront mieux comprises à la lecture de la description qui suit et à l'examen des figures qui l'accompagnent.

**BREVE DESCRIPTION DES FIGURES**

D'autres caractéristiques et avantages de l'invention ressortiront clairement de la description qui en est donnée ci-dessous, à titre indicatif et nullement limitatif, en référence aux figures annexées, parmi lesquelles :

[Fig. 1], précédemment décrite, est une vue en coupe d'une diode Schottky à barrière de jonction (JBS) selon l'art antérieur ;

[Fig. 2] représente schématiquement un premier mode de réalisation d'une diode Schottky à barrière de jonction (JBS) selon le premier aspect de l'invention ;

[Fig. 3] montre des caractéristiques I-V en direct d'une diode JBS selon la figure 2, ces caractéristiques I-V correspondant à différentes hauteurs de contact Schottky ;

[Fig. 4] montre des caractéristiques I-V en inverse de la diode JBS, ces caractéristiques I-V correspondant à différentes hauteurs de contact Schottky ;

[Fig. 5] montre des caractéristiques I-V en direct de la diode JBS, ces caractéristiques I-V correspondant à différentes largeurs de jonctions PN ;

[Fig. 6] montre des caractéristiques I-V en inverse de la diode JBS, ces caractéristiques I-V correspondant à différentes largeurs de jonctions PN ;

[Fig. 7] représente schématiquement un deuxième mode de réalisation de diode Schottky à barrière de jonction selon le premier aspect de l'invention ;

[Fig. 8] représente schématiquement un troisième mode de réalisation de diode Schottky à barrière de jonction selon le premier aspect de l'invention ; et

[Fig. 9A], [Fig. 9B], [Fig. 9C], [Fig. 9D], [Fig. 9E] et [Fig. 9F] représentent des étapes d'un procédé de fabrication de diode Schottky à barrière de jonction selon le deuxième aspect de l'invention.

Pour plus de clarté, les éléments identiques ou similaires sont repérés par des signes de référence identiques sur l'ensemble des figures.

## DESCRIPTION DETAILLEE

La figure 2 est une vue en coupe schématique d'une diode Schottky à barrière de jonction (JBS) 20 selon un premier mode de réalisation. Ce type de diode trouve des applications avantageuses en électronique de puissance, par exemple en tant que redresseur de courant ou dans des convertisseurs abaisseurs ou élévateurs de tension (convertisseurs « buck » ou « boost »).

La diode JBS 20 peut commuter de manière réversible entre un premier état appelé « état passant » (ou « état ON ») et un deuxième état appelé « état bloqué » (ou « état OFF »). Dans l'état passant, la diode JBS 20 est parcourue par un courant électrique élevé, par exemple compris entre 1 A à 100 A, et présente une tension faible à ses bornes, typiquement inférieure à 10 V. Dans l'état bloqué, seul un courant de fuite parcourt la diode et la tension à ses bornes peut être particulièrement élevée, de plusieurs centaines de volts (en valeur absolue). La diode JBS 20 est bloquée lorsqu'elle est polarisée en inverse et passante lorsqu'elle est polarisée en direct à une tension supérieure à la tension de seuil.

La diode JBS 20 comprend :

- un substrat 21 ;

- une première couche semi-conductrice 22, disposée sur une première face 21a du substrat 21 et présentant un premier type de conductivité ;

- une deuxième couche semi-conductrice 23, disposée sur une partie de la première couche semi-conductrice 22 et présentant un deuxième type de conductivité opposé au premier type de conductivité ;

- une première électrode 24 appelée ci-après « anode » comprenant une première portion 24a en contact Schottky avec la première couche semi-conductrice 22 et une deuxième portion 24b en contact ohmique avec la deuxième couche semi-conductrice 23 ;

- une deuxième électrode 25 appelée ci-après « cathode » en contact ohmique avec le substrat 21.

Dans ce premier mode de réalisation, la cathode 25 est disposée sur une deuxième face 21b du substrat 21, opposée à la première face 21a. La diode JBS 20 présente alors une architecture dite « verticale », car les deux électrodes de la diode JBS 20 sont disposées de part et d'autre du substrat 21. Le substrat 21 est de préférence formé d'un matériau semi-conducteur dopé du premier type de conductivité, par exemple de type n. Le substrat 21 est par exemple constitué de nitrure de gallium fortement dopé de type n ($n^+$-GaN). La concentration en impuretés dopantes de type n (par exemple des atomes de silicium dans le cas du GaN) du substrat 21 est de préférence comprise entre $10^{17}$ cm$^{-3}$ et $10^{20}$ cm$^{-3}$, par exemple égale à $10^{18}$ cm$^{-3}$.

La première couche semi-conductrice 22, appelée également « couche de dérive », est par exemple une couche de n-GaN, c'est-à-dire une couche de GaN dopé de type n. La concentration en impuretés dopantes de type n de la première couche semi-conductrice 22 est avantageusement inférieure à celle du substrat 21. Elle est de préférence comprise entre $10^{14}$ cm$^{-3}$ et $10^{17}$ cm$^{-3}$, par exemple égale à $10^{16}$ cm$^{-3}$. L'épaisseur $t_d$ de la première couche semi-conductrice 22 est avantageusement supérieure à 4 $\mu$m afin de conférer à la diode JBS 20 une bonne tenue en tension inverse, par exemple d'au moins 600 V (en valeurs absolue).

La première couche semi-conductrice 22 comprend une première portion 22a dite « portion de base », disposée sur le substrat 21, et une deuxième portion 22b en saillie par rapport à une face supérieure de la portion de base 22a. La portion de base 22a et la portion en saillie 22b de la première couche semi-conductrice 22 peuvent être qualifiées respectivement de « portion inférieure » et « portion supérieure ».

La portion de base 22a de la première couche semi-conductrice 22 occupe dans ce premier mode de réalisation toute la première face 21a du substrat 21.

La portion en saillie 22b de la première couche semi-conductrice 22 est délimitée latéralement par une ou plusieurs tranchées 22'. Chaque tranchée 22' permet la formation d'un contact Schottky latéral sur la première couche semi-conductrice 22. Chaque tranchée 22' peut être rectiligne et délimiter une partie (c.-à-d. un côté) seulement de la portion en saillie 22b.

Telle que représentée en coupe sur la figure 2, la portion en saillie 22b de la première couche semi-conductrice 22 peut être délimitée par deux tranchées 22' rectilignes et parallèles entre elles ou par une seule tranchée 22' annulaire, située à la périphérie de la portion en saillie 22b. La portion en saillie 22b présente alors respectivement la forme d'une ligne ou d'un cylindre.

La portion en saillie 22b de la première couche semi-conductrice 22 présente une face supérieure, de préférence orientée parallèlement à la première face 21a du substrat 21, et une ou plusieurs parois latérales, de préférence orientées perpendiculairement à la première face 21a du substrat 21.

La deuxième couche semi-conductrice 23 est disposée sur la portion en saillie 22b de la première couche semi-conductrice 22 et forme une jonction PN avec la première couche semi-conductrice 22 (ici une jonction PN$^-$ car la première couche semi-conductrice 22 est faiblement dopé de type n). De préférence, la deuxième couche semi-conductrice 23 recouvre entièrement la face supérieure de la portion en saillie 22b. Elle comprend avantageusement le même matériau semi-conducteur que celui de la première couche semi-conductrice 22. La deuxième couche semi-conductrice 23 est par exemple une couche de p-GaN, c'est-à-dire une couche de GaN dopé de type p. La concentration en impuretés dopantes de type p de la deuxième couche semi-conductrice 23 est de préférence comprise entre $10^{18}$ cm$^{-3}$ et $10^{19}$ cm$^{-3}$, par exemple égale à $10^{19}$ cm$^{-3}$, sauf éventuellement à l'interface avec la deuxième portion 24b de la première électrode 24 où elle peut être supérieure à $10^{19}$ cm$^{-3}$, par exemple égal à $10^{20}$ cm$^{-3}$.

La diode JBS 20 comprend en outre une première couche électriquement isolante 26 disposée au fond de la tranchée 22' (ou des tranchées 22' lorsque la portion en saillie 22b est délimitée par plusieurs tranchées 22'). La première couche électriquement isolante 26 empêche l'anode 24 d'être en contact électrique avec la portion de base 22a de la première couche semi-conductrice 22. La première couche électriquement isolante 26 peut être constituée d'un matériau diélectrique, par exemple du dioxyde de silicium ($SiO_2$), d'un nitrure de silicium ($Si_3N_4$ ou SiN), ou d'oxycarbure de silicium (SiOC), ou de plusieurs matériaux diélectriques empilés, par exemple un empilement bicouche $SiO_2$/SOG, un empilement bicouche $Si_3N_4$/SOG (SOG : spin on glass). Son épaisseur (totale) $t_d$ est de préférence supérieure ou égale à 0,05 $\mu$m, par exemple égale à 0,3 $\mu$m.

La première portion 24a de l'anode 24 est disposée sur la première couche électriquement isolante 26 et contre une ou plusieurs parois latérales de la portion en saillie 22b. Elle recouvre avantageusement toute la surface latérale de la portion en saillie 22b. Elle forme un contact Schottky avec la première couche semi-conductrice 22, ici en n-GaN. Ainsi, le contact Schottky de la diode JBS 20 peut être limité à une ou plusieurs parois latérales de la portion en saillie 22b.

La deuxième portion 24b de l'anode 24 forme un contact ohmique avec la deuxième couche semi-conductrice 23, ici en p-GaN. Elle est de préférence disposée sur la face supérieure de la deuxième couche semi-conductrice 23.

Comme cela est représenté sur la figure 2, la première portion 24a de l'anode 24 peut être formée par une première couche métallique, en contact Schottky avec la portion en saillie 22b de la première couche semi-conductrice 22, et la deuxième portion 24b de l'anode 24 peut être formée par une deuxième couche métallique, en contact ohmique avec la deuxième couche semi-conductrice 23.

La première couche métallique est constituée d'un premier métal et la deuxième couche métallique est constituée d'un deuxième métal, distinct du premier métal. La hauteur de barrière du contact Schottky et la résistance de contact entre la deuxième couche métallique et la deuxième couche semi-conductrice 23 (contact ohmique) peuvent être ainsi toutes les deux optimisées, en choisissant deux métaux ayant des travaux de sortie différents. Chacune des première et deuxième couches métalliques peut être constituée d'un métal pur ou d'un alliage métallique.

Lorsque la première couche semi-conductrice 22 présente un dopage de type n et la deuxième couche semi-conductrice 23 présente un dopage de type p, le deuxième métal présente avantageusement un travail de sortie supérieur au travail de sortie du premier métal. Par exemple, le premier métal est choisi parmi le nitrure de titane (TiN), l'aluminium (Al) et le nitrure de tantale (TaN), tandis que le deuxième métal est choisi parmi le nickel (Ni), le platine (Pt), l'or (Au) et le palladium (Pd).

Chacune des première et deuxième couches métalliques peut être recouverte d'une ou plusieurs autres couches métalliques (non représentées sur la figure 2) pour former un empilement multicouche, par exemple un empilement bicouche du type Ni/Au.

La deuxième couche métallique peut s'étendre sur la première couche métallique. Par ailleurs, la première couche métallique peut s'étendre sur la deuxième couche semi-conductrice 23. De façon avantageuse, la diode JBS 20 comprend une deuxième couche électriquement isolante 27 disposée sur une partie de la deuxième couche semi-conductrice 23. Cette deuxième couche électriquement isolante 27 limite le contact entre la première couche métallique et la deuxième couche semi-conductrice 23.

Dans une variante de réalisation non représentée par les figures, les première et deuxième portions 24a-24b de l'anode 24 sont formées par une même couche métallique, en contact Schottky avec la première couche semi-conductrice 22 et en contact ohmique avec la deuxième couche semi-conductrice 23. Cette couche métallique peut être constituée d'un métal pur (ex. nickel, platine, palladium, or, argent...) ou d'un alliage métallique. Elle peut être aussi recouverte d'une ou plusieurs autres couches métalliques pour former un empilement multicouche.

La diode JBS 20 peut présenter, comme cela est représenté sur la figure 2, un axe de symétrie vertical passant par la portion en saillie 22b. Lorsque la portion en saillie 22b est délimitée par deux tranchées 22' rectilignes et parallèles entre elles, la première couche électriquement isolante 26 est avantageusement disposée au fond de chaque tranchée 22', de part et d'autre de la portion en saillie 22b, et la première portion 24a de l'anode 24 est avantageusement disposée contre deux parois latérales opposées de la portion en saillie 22b. Lorsque la portion en saillie 22b est délimitée par une seule tranchée 22' annulaire, la première couche électriquement isolante 26 et la première portion 24a de l'anode 24 sont avantageusement disposées à la périphérie de la portion en saillie 22b, respectivement au fond de la tranchée 22' annulaire et contre la paroi latérale annulaire de la portion en saillie 22b.

D'un point de vue électrique, la diode JBS 20 comprend une diode Schottky et une diode PIN couplées en parallèle (la zone intrinsèque « I » correspondant à la première couche semi-conductrice 22 faiblement dopé de type n). La diode JBS présente un comportement essentiellement Schottky en fonctionnement nominal, c'est-à-dire à faible tension de polarisation directe, et un comportement essentiellement bipolaire à plus forte tension de polarisation directe, ce qui lui permet de supporter des surcharges en courant.

Sous polarisation inverse, la portion en saillie 22b de la première couche semi-conductrice 22 est déplétée sous l'effet de la jonction PN et de la jonction Schottky, créant une barrière de potentiel entre l'anode 24 et la cathode 25. Cette barrière de potentiel réduit le champ électrique dans la portion en saillie 22b de la première couche semi-conductrice 22 et, par conséquent, le courant de fuite en inverse de la diode.

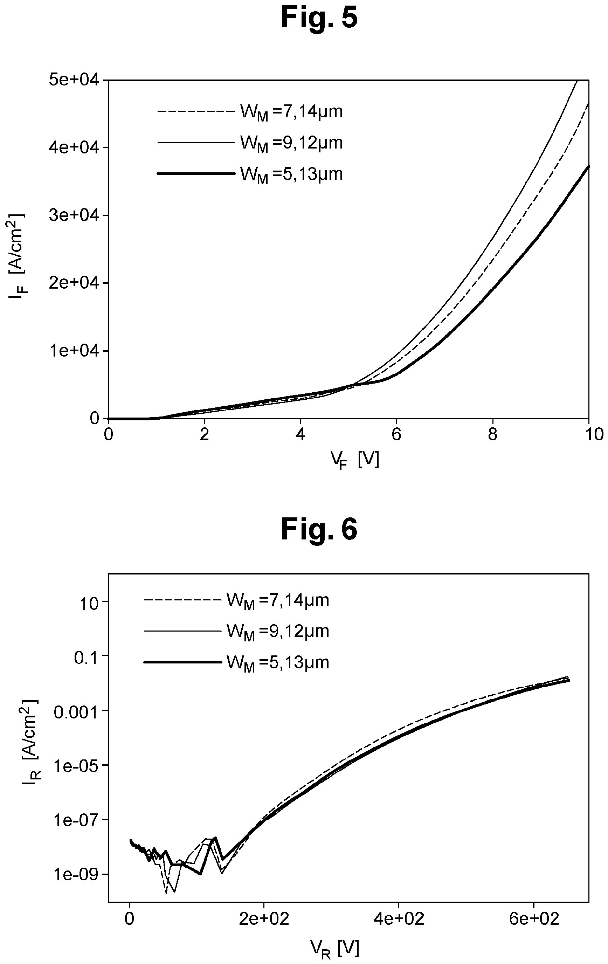

La diode JBS 20 est remarquable en ce que la surface de la jonction PN (définie comme la surface de contact entre la première couche semi-conductrice 22 et la deuxième couche semi-conductrice 23) et la surface de la jonction Schottky (définie comme la surface de contact entre la première portion 24a de l'anode 24 et la première couche semi-conductrice 22) sont situées dans des plans sécants et, de préférence, orthogonaux. Ainsi, la surface de la jonction PN peut être augmentée sans que cela n'ait d'impact sur la surface de la jonction Schottky, et inversement. Ceci apporte plus de souplesse dans le dimensionnement de la diode JBS et permet d'ajuster un des paramètres électriques de la diode JBS de façon indépendante, comme décrit ci-après en relation avec les figures 5 et 6.

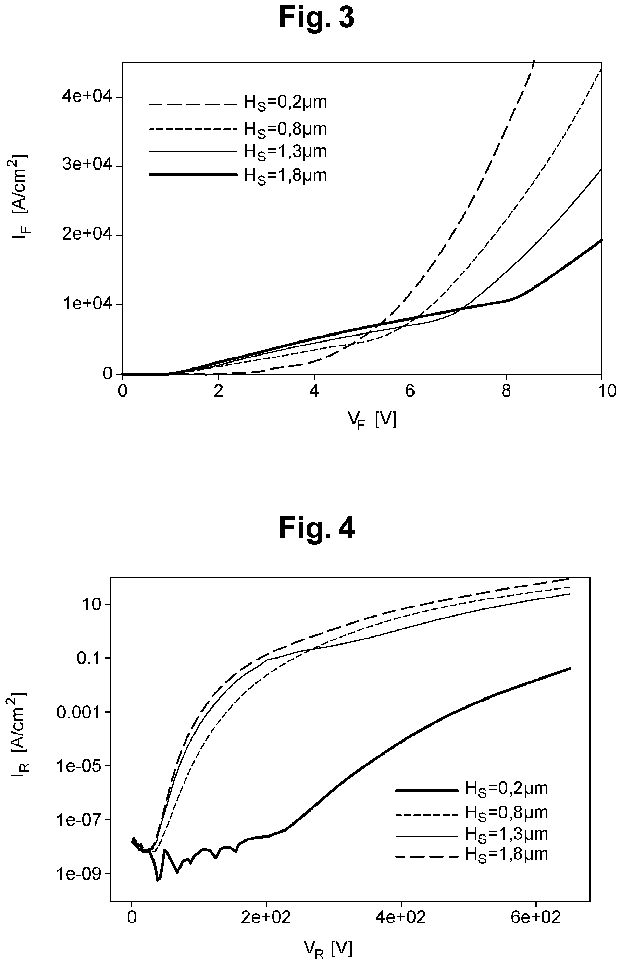

La figure 3 représente la densité de courant en direct I$_F$ d'une diode JBS 20 selon la figure 2 en fonction de la tension de polarisation directe V$_F$, pour différentes valeurs de hauteur de contact Schottky Hs. La densité de courant I$_F$ est normalisée en divisant le courant total de la diode par la surface totale de la diode.

La hauteur de contact Schottky Hs est la dimension de la surface de la jonction Schottky mesurée perpendiculairement à la première face 21a du substrat 21. Dans le mode de réalisation de la figure 2, la hauteur de contact Schottky Hs est donnée par la relation suivante :

[Math 1]

$$H_S = t_M - t_d$$

où t$_M$ est l'épaisseur de la portion en saillie 22b de la première couche semi-conductrice 22 et t$_d$ est l'épaisseur de la première couche électriquement isolante 26.

La figure 3 montre que le courant en fonctionnement nominal (c'est-à-dire en fonctionnement Schottky) et la tension de basculement entre le fonctionnement nominal (mode de conduction Schottky) et le fonctionnement en surcharge de courant (mode de conduction bipolaire) augmentent lorsque la hauteur de contact Schottky Hs augmente.

La figure 4 représente, pour cette même diode JBS et pour les mêmes valeurs de hauteur de contact Schottky Hs, la densité de courant en inverse I$_R$ en fonction de la tension de polarisation inverse V$_R$ (en valeur absolue). On remarque que le courant de fuite diminue lorsque la hauteur de contact Schottky Hs diminue. Il atteint une valeur minimale lorsque la hauteur de contact Schottky Hs est sensiblement égale ou inférieure à la hauteur de la zone de charge d'espace de la jonction PN.

Ainsi, le courant de fonctionnement nominal et le courant de fuite en inverse de la diode JBS 20 peuvent être ajustés en faisant varier la hauteur de contact Schottky H$_S$.

D'une manière générale, un bon compromis entre courant de fonctionnement nominal et courant de fuite en inverse peut être obtenu pour une hauteur de contact Schottky Hs comprise entre 0,1 μm et 3 μm.

Le croisement des courbes Hs = 0,8 μm et H$_S$ = 1,3 μm est attribué à la différence de l'angle entre la paroi latérale de la portion en saillie 22b et la première couche électriquement isolante 26. Cet angle est réduit dans le cas Hs = 1,3 μm du fait d'une profondeur de gravure plus importante.

La figure 5 représente la densité de courant en direct I$_F$ de la diode JBS en fonction de la tension de polarisation directe V$_F$ pour différentes valeurs de largeur de jonction PN W$_M$. La largeur de jonction PN W$_M$ correspond ici à la largeur de la portion en saillie 22b, mesurée parallèlement à la première face 21a du substrat 21 dans le plan de coupe de la figure 2 (typiquement la distance entre deux tranchées rectilignes parallèles ou le diamètre intérieur de la tranchée annulaire).

Cette figure montre que le courant admissible en surcharge (pour une tension de polarisation directe donnée) augmente avec la largeur de jonction PN W$_M$. En revanche, la largeur de jonction PN W$_M$ n'a quasiment aucune influence sur le courant de fonctionnement nominal.

D'après la figure 6, qui représente la densité de courant en inverse I$_R$ de la diode JBS en fonction de la tension de polarisation inverse V$_R$ pour les mêmes valeurs de largeur de jonction PN W$_M$, la largeur de jonction PN W$_M$ n'a pas non plus d'impact significatif sur le courant de fuite en inverse.

En jouant sur la largeur (ou le diamètre) de la portion en saillie 22b de la première couche semi-conductrice 22, il est donc possible d'ajuster le courant admissible en surcharge de la diode JBS de façon indépendante du courant de fonctionnement nominal et du courant de fuite en inverse. La largeur (W$_M$) de la portion en saillie 22b de la première couche semi-conductrice 22 est de préférence comprise entre 3 μm et 10 μm. La largeur des tranchées 22' peut être comprise entre 1 μm et 5 μm.

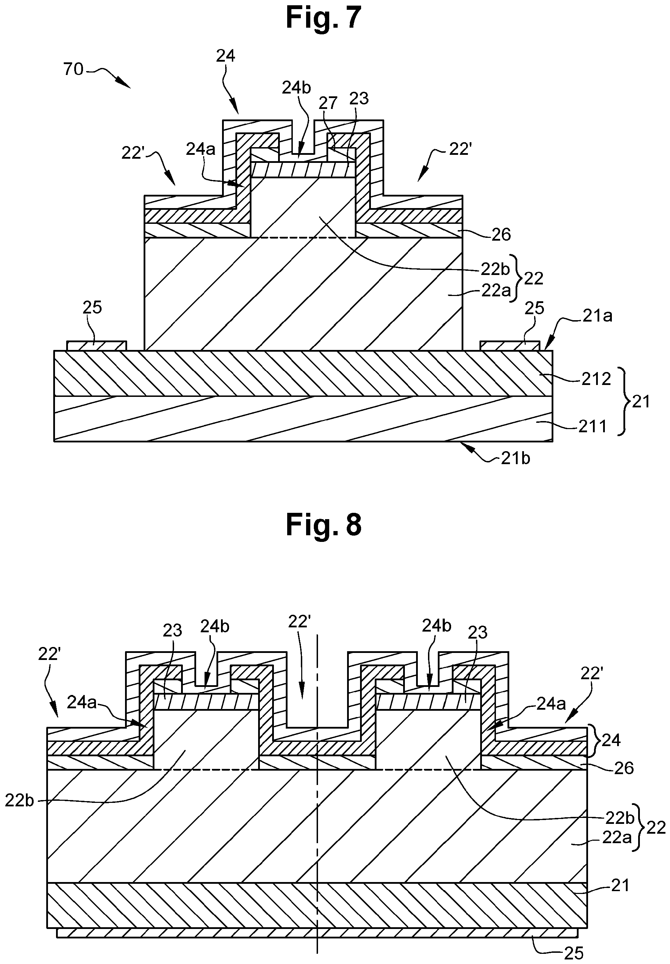

La figure 7 est une vue en coupe schématique d'une diode JBS 70 selon un deuxième mode de réalisation. La diode JBS 70 selon le deuxième mode de réalisation présente une architecture dite « pseudo-verticale ». Elle diffère de la diode JBS 20 selon le premier mode de réalisation (Fig. 2) en ce que la cathode 25 est disposée sur une portion libre de la première face 21a du substrat 21 (et non plus sur la deuxième face 21b du substrat 21).

Ainsi, dans ce deuxième mode de réalisation, la première couche semi-conductrice 22 n'occupe qu'une partie de la première face 21a du substrat 21. La cathode 25 est avantageusement disposée de façon symétrique par rapport à l'empilement comprenant la première couche semi-conductrice 22, la deuxième couche semi-conductrice 23, l'anode 24 et la première couche électriquement isolante 26.

Le substrat 21 de la diode JBS 70 peut être un substrat dit « hybride » comprenant une couche de support 211, par exemple en silicium, carbure de silicium (SiC) ou saphir, et une couche de croissance 212 en matériau semi-conducteur dopé du premier type de conductivité (par exemple en $n^+$-GaN) disposée sur la couche de support 211. Le substrat 21 peut être alternativement un substrat massif ou « autoportant » constitué du matériau semi-conducteur dopé du premier type de conductivité.

La première couche semi-conductrice 22, la deuxième couche semi-conductrice 23 et l'anode 24 étant configurées de la même façon que dans le premier mode de réalisation, la diode JBS 70 bénéficie des mêmes avantages que la diode JBS 20 en termes de dimensionnement.

Dans un troisième mode de réalisation de diode JBS représenté par la figure 8, la première couche semi-conductrice 22 comprend une pluralité de portions en saillie 22b (par exemple en forme de lignes ou de cylindres) délimitées chacune latéralement par une ou plusieurs tranchées 22'. La deuxième couche semi-conductrice 23 est disposée (ou répartie) sur la pluralité de portions en saillie 22b de la première couche semi-conductrice 22. La première portion 24a de l'anode 24 est disposée contre au moins une paroi latérale de chaque portion en saillie 22b et avantageusement contre toute la surface latérale des portions en saillie 22b. Elle est séparée de la portion de base 22a de la première couche semi-conductrice 22 par la première couche électriquement isolante 26. Cette dernière recouvre avantageusement le fond de chaque tranchée 22'. La deuxième portion 24b de l'anode 24 est disposée sur chacune des portions en saillie 22b de la première couche semi-conductrice 22, en contact avec la deuxième couche conductrice 23.

Autrement dit, la structure de diode JBS représentée par la figure 2 (ou la figure 3) peut être dupliquée latéralement pour former un composant de plus grande surface et donc de plus grand calibre en courant.

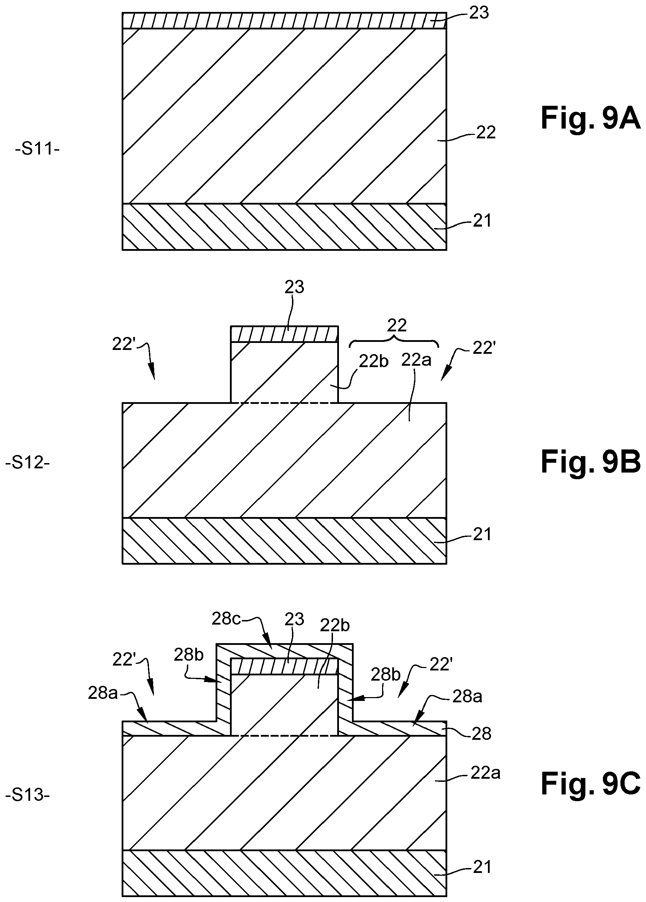

Un exemple de procédé de fabrication de diode Schottky à barrière de jonction (JBS) va maintenant être décrit en référence aux figures 9A à 9F. Ces figures représentent schématiquement des étapes S11 à S16 pour fabriquer la diode JBS 20 de la figure 2.

L'étape S11 de la figure 9A consiste à fournir un empilement comprenant successivement le substrat 21, la première couche semi-conductrice 22 (dopée du premier type de conductivité) et la deuxième couche semi-conductrice 23 (dopée du deuxième type de conductivité). Les première et deuxième couches semi-conductrices 22-23, par exemple en GaN, sont de préférence formées par épitaxie. Le substrat 21 sert alors de support de croissance aux première et deuxième couches semi-conductrices 22-23.

A l'étape S12 de [Fig. 9B], au moins une tranchée 22' est gravée dans la deuxième couche semi-conductrice 23 et dans une partie de la première couche conductrice 22 sous-jacente pour délimiter (au moins en partie) la portion de base 22a et la portion en saillie 22b de la première couche conductrice 22 et limiter la deuxième couche semi-conductrice 23 à la portion en saillie 22b de la première couche semi-conductrice 22.

La gravure de la tranchée 22' dans les première et deuxième couches semi-conductrices 22-23 présente avantageusement un coefficient d'isotropie supérieur ou égal à 0,3. Le coefficient d'isotropie est défini comme le rapport de la vitesse de gravure latérale sur la vitesse de gravure verticale. Des angles arrondis avec un plus grand rayon de courbure peuvent être ainsi obtenus au fond de la tranchée. Ces angles permettent de diminuer le champ électrique dans la première couche électrique isolante disposée au fond de la tranchée et de réduire davantage le courant de fuite en inverse de la diode JBS.

Dans un souci de clarté, les étapes suivantes du procédé de fabrication seront décrites en référence à une seule tranchée 22' (par exemple annulaire). Elles peuvent néanmoins être accomplies de la même façon avec plusieurs tranchées (par exemple rectilignes).

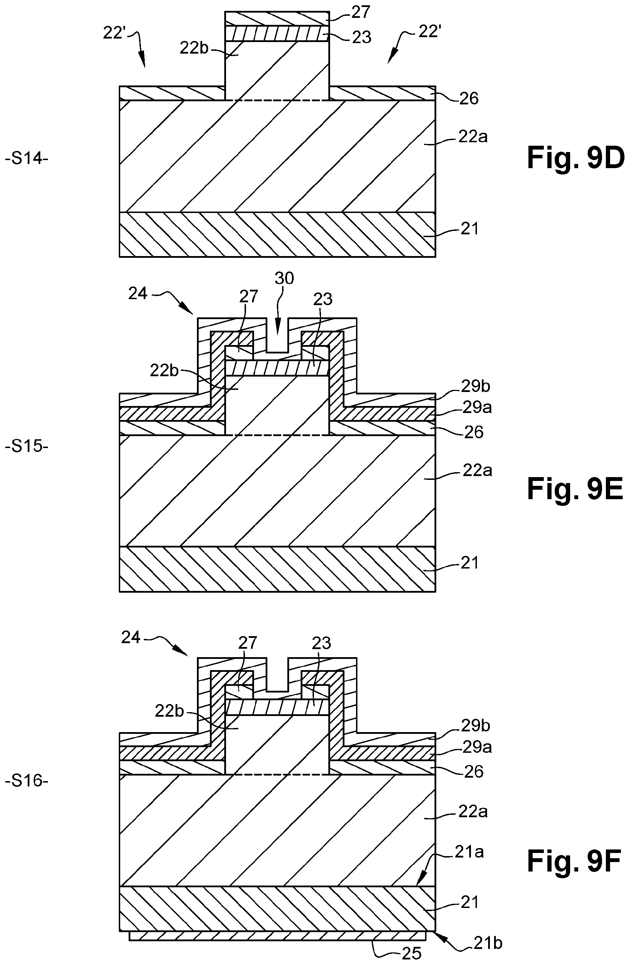

Le procédé de fabrication comprend ensuite la formation de la première couche électriquement isolante 26 au fond de la tranchée 22'. Dans cet exemple, la formation de la première couche électriquement isolante 26 comprend les étapes S13 et S14 représentées respectivement par les figures 9C et 9D.

A l'étape S13 (cf. [Fig. 9C]), la première couche semi-conductrice 22 est recouverte d'une couche de matériau diélectrique 28. Cette couche de matériau diélectrique 28 comprend une première portion 28a disposée sur la portion de base 22a, au fond de la tranchée 22', et une deuxième portion 28b disposée contre au moins une paroi latérale de la portion en saillie 22b. La première portion 28a présente une épaisseur supérieure à celle de la deuxième portion 28b. La couche de matériau diélectrique 28 peut être obtenue par un dépôt non-conforme de matériau diélectrique, par exemple en $SiO_2$. La couche de matériau diélectrique 28 recouvre de préférence toute la surface du substrat (dépôt dit « pleine plaque »), et donc toute la surface latérale de la portion en saillie 22b.

L'étape S14 (cf. [Fig. 9D]) est une étape de gravure isotrope de la couche de matériau diélectrique 28, accomplie de façon à retirer uniquement la deuxième portion 28b de la couche de matériau diélectrique 28. La première portion 28a de la couche de matériau diélectrique 28 n'est que partiellement gravée et forme la première couche électriquement isolante 26.

La couche de matériau diélectrique 28 peut également comprendre une troisième portion 28c recouvrant la deuxième couche semi-conductrice 23 (cf. Fig. 9C). Cette troisième portion 28c de la couche de matériau diélectrique 28 présente initialement une épaisseur supérieure à celle de la deuxième portion 28b et forme après l'étape S14 de gravure isotrope la deuxième couche électriquement isolante 27 (cf. Fig. 9D).

En référence à [Fig. 9E], le procédé comprend ensuite une étape S15 de formation de l'anode 24, et plus particulièrement des contacts Schottky et ohmique sur respectivement les première et deuxième couches semi-conductrices 22-23. La formation de l'anode 24 peut notamment comprendre les opérations suivantes :

- dépôt d'une première couche métallique 29a sur la première couche électriquement isolante 26, contre la paroi latérale de la portion en saillie 22b de la première couche semi-conductrice 22 et sur la deuxième couche semi-conductrice 23 ;

- réalisation dans la première couche métallique 29a (et dans la deuxième couche électriquement isolante 27, le cas échéant) d'une ouverture 30 débouchant sur la deuxième couche semi-conductrice 23 ;

- dépôt d'une deuxième couche métallique 29b dans l'ouverture 30, en contact avec la deuxième couche semi-conductrice 23, et avantageusement sur la première couche métallique 29a.

Les première et deuxième couches métalliques 29a-29b sont de préférence déposées sur toute la surface du substrat (dépôt pleine plaque), par exemple par voie chimique (ex. évaporation) ou physique (ex. pulvérisation cathodique). Le dépôt peut être conforme ou non conforme.

En référence à [Fig. 9F], le procédé de fabrication comprend en outre une étape S16 de formation de la cathode 25, ici sur la deuxième face opposée 21b du substrat 21.

Le procédé de fabrication de la diode JBS 70 selon la figure 7 comprend, outre les étapes S11-S16 décrites précédemment, une étape de gravure des première et deuxième couches semi-conductrice 22-23 jusqu'au substrat 21, pour libérer une portion de la première face 21a du substrat (portion sur laquelle sera formée l'anode 25).

La diode JBS selon l'invention n'est pas limitée aux modes de réalisation décrits en référence aux figures 2, 7-8 et de nombreuses variantes et modifications apparaîtront à l'homme du métier. En particulier, le substrat 21, la première couche semi-conductrice 22 et/ou la deuxième couche semi-conductrice 23 de la diode JBS peuvent comprendre un matériau semi-conducteur autre que le GaN, par exemple du carbure de silicium (SiC) ou du silicium (Si).

## Revendications

1. Diode Schottky à barrière de jonction (20, 70) comprenant :

   - un substrat (21) ;
   - une première couche semi-conductrice (22), disposée sur une première face (21a) du substrat (21) et présentant un premier type de conductivité, la première couche semi-conductrice (22) comprenant une portion en saillie (22b) délimitée par une tranchée (22') ;
   - une deuxième couche semi-conductrice (23) disposée sur la portion en saillie (22b) de la première couche semi-conductrice (22) et présentant un deuxième type de conductivité opposé au premier type de conductivité ;
   - une couche électriquement isolante (26) disposée au fond de la tranchée (22') ;
   - une première électrode (24) comprenant :

     ○ une première portion (24a) en contact Schottky avec la première couche semi-conductrice (22), la première portion de la première électrode étant disposée sur la couche électriquement isolante (26) et contre une paroi latérale de la portion en saillie (22b) de la première couche semi-conductrice (22) ;

     o une deuxième portion (24b) en contact ohmique avec la deuxième couche semi-conductrice (23) ;

   - une deuxième électrode (25) en contact ohmique avec le substrat (21).

2. Diode (20, 70) selon la revendication 1, dans laquelle le contact Schottky présente une hauteur (Hs) comprise entre 0,1 μm et 3 μm.

3. Diode (20, 70) selon l'une des revendications 1 et 2, dans laquelle la première portion (24a) de la première électrode (24) est formée par une couche d'un premier métal et la deuxième portion (24b) de la première électrode (24) est formée par une couche d'un deuxième métal, distinct du premier métal.

4. Diode (20, 70) selon la revendication 3, dans laquelle le deuxième métal présente un travail de sortie supérieur au travail de sortie du premier métal.

5. Diode (20) selon l'une quelconque des revendications 1 à 4, dans laquelle la deuxième électrode (25) est disposée sur une deuxième face (21b) du substrat (21) opposée à la première face (21a).

6. Diode (70) selon l'une quelconque des revendications 1 à 4, dans laquelle la première couche semi-conductrice (22) occupe une partie seulement de la première face (21a) du substrat (21) et la deuxième électrode (25) est disposée sur la première face du substrat.

7. Diode (20, 70) selon l'une quelconque des revendications 1 à 6, dans laquelle la première couche semi-conductrice (21) comprend une pluralité de portions en saillie (22b) délimitées chacune par une tranchée (22'), la deuxième couche semi-conductrice (23) est disposée sur la pluralité de portions en saillie (22b) de la première couche semi-conductrice (22), la première portion (24a) de la première électrode (24) est disposée contre une paroi latérale de chaque portion en saillie (22b) de la première couche semi-conductrice (22) et la deuxième portion (24b) de la première électrode (24) est disposée sur chaque portion en saillie (22b) de la première couche semi-conductrice (22) en contact avec la deuxième couche semi-conductrice (23).

8. Diode (20, 70) selon l'une quelconque des revendications 1 à 7, dans lequel la surface de contact entre la première couche semi-conductrice (22) et la deuxième couche semi-conductrice (23) et la surface de contact entre la première portion (24a) de la première électrode (24) et la première couche semi-conductrice (22) sont situées dans des plans sécants.

9. Procédé de fabrication d'une diode Schottky à barrière de jonction (20, 70) comprenant les étapes suivantes :

    - former (S11) un empilement comprenant successivement un substrat (21), une première couche semi-conductrice (22) présentant un premier type de conductivité et une deuxième couche (23) présentant un deuxième type de conductivité opposé au premier type de conductivité ;
    - graver (S12) une tranchée (22') dans la deuxième couche semi-conductrice (23) et une partie de la première couche semi-conductrice (22), de manière à délimiter une portion en saillie (22b) de la première couche semi-conductrice et à limiter la deuxième couche semi-conductrice (23) à la portion en saillie (22b) de la première couche semi-conductrice (22) ;
    - former (S13, S14) une couche électriquement isolante (26) au fond de la tranchée (22') ;
    - former (S15) une première électrode (24) comprenant :

        o une première portion (24a) en contact Schottky avec la première couche semi-conductrice (22), la première portion de la première électrode étant disposée sur la couche électriquement isolante (26) et contre une paroi latérale de la portion en saillie (22b) de la première couche semi-conductrice (22) ;
        o une deuxième portion (24b) en contact ohmique avec la deuxième couche semi-conductrice (23) ;

    - former (S16) une deuxième électrode (25) en contact ohmique avec le substrat (21).

10. Procédé selon la revendication 9, dans lequel l'étape de gravure de la tranchée (22') présente un coefficient d'isotropie supérieur à 0,3.

11. Procédé selon l'une des revendications 9 et 10, dans lequel l'étape de formation de la couche électriquement isolante (26) au fond de la tranchée (22') comprend les opérations suivantes :

    - former (S13) une couche de matériau diélectrique (28) comprenant une première portion (28a) disposée au fond de la tranchée et une deuxième portion (28b) disposée contre la paroi latérale de la portion en saillie (22b) de la première couche semi-conductrice (22), la première portion (28a) présentant une épaisseur supérieure à celle de la deuxième portion (28b) ; et
    - graver (S14) de manière isotrope la couche de matériau diélectrique (28) de façon à retirer uniquement la deuxième portion (28b).

12. Procédé selon l'une quelconque des revendications 9 à 11, dans lequel l'étape de formation de la première électrode (24) comprend les opérations suivantes :

    - déposer une couche (29a) d'un premier métal sur la couche électriquement isolante (26), contre la paroi latérale de la portion en saillie (22b) de la première couche semi-conductrice (22) et sur la deuxième couche semi-conductrice (23) ;
    - former dans la couche (29a) du premier métal une ouverture (30) débouchant sur la deuxième couche semi-conductrice (23) ;
    - déposer une couche (29b) d'un deuxième métal dans l'ouverture (30), en contact avec la deuxième couche semi-conductrice (23), le deuxième métal étant distinct du premier métal.

**Patentansprüche**

1. Schottky-Sperrschicht-Diode (20, 70) bestehend aus:

    - einem Substrat (21);
    - einer ersten Halbleiterschicht (22), die auf einer ersten Seite (21a) des Substrats (21) angeordnet ist und einen ersten Leitfähigkeitstyp aufweist, wobei die erste Halbleiterschicht (22) einen vorspringenden Abschnitt (22b) umfasst, der durch einen Graben (22') begrenzt wird;
    - einer zweiten Halbleiterschicht (23), die auf dem vorspringenden Abschnitt (22b) der ersten Halbleiterschicht (22) angeordnet ist und einen zweiten Leitfähigkeitstyp aufweist, der dem ersten Leitfähigkeitstyp entgegengesetzt ist;
    - einer elektrisch isolierenden Schicht (26), die am Grund des Grabens (22') angeordnet ist;
    - einer ersten Elektrode (24) bestehend aus:

        o einem ersten Abschnitt (24a) im Schottky-Kontakt mit der ersten Halbleiterschicht (22), wobei der erste Abschnitt der ersten Elektrode auf der elektrisch isolierenden Schicht (26) und an einer Seitenwand des vorspringenden Abschnitts (22b) der ersten Halbleiterschicht (22) angeordnet ist;
        o einem zweiten Abschnitt (24b) in ohmschem Kontakt mit der zweiten Halbleiterschicht (23) ;

    - einer zweiten Elektrode (25) in ohmschem Kontakt mit dem Substrat (21).

**2.** Diode (20, 70) nach Anspruch 1, **dadurch gekennzeichnet, dass** der Schottky-Kontakt eine Höhe (Hs) zwischen 0,1 $\mu$m und 3 $\mu$m aufweist.

**3.** Diode (20, 70) nach einem der Ansprüche 1 und 2, **dadurch gekennzeichnet, dass** der erste Abschnitt (24a) der ersten Elektrode (24) durch eine Schicht aus einem ersten Metall gebildet wird und der zweite Abschnitt (24b) der ersten Elektrode (24) durch eine Schicht aus einem zweiten Metall gebildet wird, das sich von dem ersten Metall unterscheidet.

**4.** Diode (20, 70) nach Anspruch 3, **dadurch gekennzeichnet, dass** das zweite Metall eine höhere Austrittsarbeit als die Austrittsarbeit des ersten Metalls aufweist.

**5.** Diode (20) nach einem der Ansprüche 1 bis 4, **dadurch gekennzeichnet, dass** die zweite Elektrode (25) auf einer zweiten Seite (21b) des Substrats (21) angeordnet ist, die der ersten Seite (21a) gegenüberliegt.

**6.** Diode (70) nach einem der Ansprüche 1 bis 4, **dadurch gekennzeichnet, dass** die erste Halbleiterschicht (22) nur einen Teil der ersten Seite (21a) des Substrats (21) einnimmt und die zweite Elektrode (25) auf der ersten Seite des Substrats angeordnet ist.

**7.** Diode (20, 70) nach einem der Ansprüche 1 bis 6, **dadurch gekennzeichnet, dass** die erste Halbleiterschicht (21) eine Vielzahl von vorspringenden Abschnitten (22b) umfasst, die jeweils durch einen Graben (22') begrenzt sind, die zweite Halbleiterschicht (23) auf der Vielzahl von vorspringenden Abschnitten (22b) der ersten Halbleiterschicht (22) angeordnet ist, der erste Abschnitt (24a) der ersten Elektrode (24) an einer Seitenwand jedes vorstehenden Abschnitts (22b) der ersten Halbleiterschicht (22) angeordnet ist und der zweite Abschnitt (24b) der ersten Elektrode (24) auf jedem vorstehenden Abschnitt (22b) der ersten Halbleiterschicht (22) in Kontakt mit der zweiten Halbleiterschicht (23) angeordnet ist.

**8.** Diode (20, 70) nach einem der Ansprüche 1 bis 7, **dadurch gekennzeichnet, dass** die Kontaktfläche zwischen der ersten Halbleiterschicht (22) und der zweiten Halbleiterschicht (23) und die Kontaktfläche zwischen dem ersten Abschnitt (24a) der ersten Elektrode (24) und der ersten Halbleiterschicht (22) in sich schneidenden Ebenen angeordnet sind.

**9.** Verfahren zur Herstellung einer Schottky-Sperrschicht-Diode (20, 70) bestehend aus den folgenden Schritten:

    - Bilden (S11) eines Stapels, der nacheinander ein Substrat (21), eine erste Halbleiterschicht (22) mit einem ersten Leitfähigkeitstyp und eine zweite Schicht (23) mit einem zweiten Leitfähigkeitstyp, der dem ersten Leitfähigkeitstyp entgegengesetzt ist, umfasst;
    - Ätzen (S12) eines Grabens (22') in die zweite Halbleiterschicht (23) und in einen Teil der ersten Halbleiterschicht (22), um auf diese Weise einen vorstehenden Abschnitt (22b) der ersten Halbleiterschicht zu begrenzen und die zweite Halbleiterschicht (23) auf den vorstehenden Abschnitt (22b) der ersten Halbleiterschicht (22) zu begrenzen;
    - Bilden (S13, S14) einer elektrisch isolierenden Schicht (26) am Grund des Grabens (22');
    - Bilden (S15) einer ersten Elektrode (24) bestehend aus:

        o einem ersten Abschnitt (24a) im Schottky-Kontakt mit der ersten Halbleiterschicht (22), wobei der erste Abschnitt der ersten Elektrode auf der elektrisch isolierenden Schicht (26) und an einer Seitenwand des vorspringenden Abschnitts (22b) der ersten Halbleiterschicht (22) angeordnet ist;
        o einem zweiten Abschnitt (24b) in ohmschem Kontakt mit der zweiten Halbleiterschicht (23) ;

- Bilden (S16) einer zweiten Elektrode (25) in ohmschem Kontakt mit dem Substrat (21).

**10.** Verfahren nach Anspruch 9, **dadurch gekennzeichnet, dass** der Schritt des Ätzens des Grabens (22') einen Isotropie-Koeffizient von mehr als 0,3 aufweist.

**11.** Verfahren nach einem der Ansprüche 9 und 10, **dadurch gekennzeichnet, dass** der Schritt des Bildens der elektrisch isolierenden Schicht (26) am Grund des Grabens (22') die folgenden Schritte umfasst:

- Bilden (S13) einer Schicht aus dielektrischem Material (28), die einen ersten Abschnitt (28a), der am Grund des Grabens angeordnet ist, und einen zweiten Abschnitt (28b), der an der Seitenwand des vorstehenden Abschnitts (22b) der ersten Halbleiterschicht (22) angeordnet ist, umfasst, wobei der erste Abschnitt (28a) eine größere Dicke als der zweite Abschnitt (28b) aufweist; und
- isotropes Ätzen (S14) der Schicht aus dielektrischem Material (28), so dass nur der zweite Abschnitt (28b) entfernt wird.

**12.** Verfahren nach einem der Ansprüche 9 bis 11, **dadurch gekennzeichnet, dass** der Schritt des Bildens der ersten Elektrode (24) die folgenden Schritte umfasst:

- Abscheiden einer Schicht (29a) aus einem ersten Metall auf der elektrisch isolierenden Schicht (26), auf der Seitenwand des vorstehenden Abschnitts (22b) der ersten Halbleiterschicht (22) und auf der zweiten Halbleiterschicht (23) ;
- Bilden einer Öffnung (30) in der Schicht (29a) des ersten Metalls, die in die zweite Halbleiterschicht (23) mündet;
- Abscheiden einer Schicht (29b) aus einem zweiten Metall in der Öffnung (30) in Kontakt mit der zweiten Halbleiterschicht (23), wobei sich das zweite Metall von dem ersten Metall unterscheidet.

**Claims**

**1.** Junction barrier Schottky diode (20, 70) comprising:

- a substrate (21);
- a first semiconductor layer (22) arranged on a first face (21a) of the substrate (21) and having a first type of conductivity, the first semiconductor layer (22) comprising a projecting portion (22b) delimited by a trench (22');
- a second semiconductor layer (23) arranged on the projecting portion (22b) of the first semiconductor layer (22) and having a second type of conductivity opposite to the first type of conductivity;
- an electrically insulating layer (26) arranged at the bottom of the trench (22');
- a first electrode (24) comprising:

o a first portion (24a) in Schottky contact with the first semiconductor layer (22), the first portion of the first electrode being arranged on the electrically insulating layer (26) and against a side wall of the projecting portion (22b) of the first semiconductor layer (22);
○ a second portion (24b) in ohmic contact with the second semiconductor layer (23);

- a second electrode (25) in ohmic contact with the substrate (21).

**2.** Diode (20, 70) according to claim 1, wherein the Schottky contact has a height (Hs) comprised between 0.1 $\mu$m and 3 $\mu$m.

**3.** Diode (20, 70) according to one of claims 1 and 2, wherein the first portion (24a) of the first electrode (24) is formed by a layer of a first metal and the second portion (24b) of the first electrode (24) is formed by a layer of a second metal, distinct from the first metal.

**4.** Diode (20, 70) according to claim 3, wherein the second metal has a work function greater than the work function of the first metal.

**5.** Diode (20) according to any one of claims 1 to 4, wherein the second electrode (25) is arranged on a second face (21b) of the substrate (21) opposite to the first face (21a).

**6.** Diode (70) according to any one of claims 1 to 4, wherein the first semiconductor layer (22) only occupies a part of the first face (21a) of the substrate (21) and the second electrode (25) is arranged on the first face of the substrate.

**7.** Diode (20, 70) according to any one of claims 1 to 6, wherein the first semiconductor layer (21) comprises a plurality of projecting portions (22b) each delimited by a trench (22'), the second semiconductor layer (23) is arranged on the plurality of projecting portions (22b) of the first semiconductor layer (22), the first portion (24a) of the first electrode (24) is arranged against a side wall of each projecting portion (22b) of the first semiconductor layer (22) and the second portion (24b) of the first electrode (24) is arranged on each projecting portion (22b) of the first semiconductor layer (22) in contact with the second semiconductor layer (23).

8. Diode (20, 70) according to any one of claims 1 to 7, wherein the contact surface between the first semiconductor layer (22) and the second semiconductor layer (23) and the contact surface between the first portion (24a) of the first electrode (24) and the first semiconductor layer (22) are situated in secant planes.

9. Method for manufacturing a junction barrier Schottky diode (20, 70) comprising the following steps:

   - forming (S11) a stack comprising successively a substrate (21), a first semiconductor layer (22) having a first type of conductivity and a second layer (23) having a second type of conductivity opposite to the first type of conductivity;
   - etching (S12) a trench (22') in the second semiconductor layer (23) and a part of the first semiconductor layer (22), so as to delimit a projecting portion (22b) of the first semiconductor layer and to limit the second semiconductor layer (23) to the projecting portion (22b) of the first semiconductor layer (22);
   - forming (S13, S14) an electrically insulating layer (26) at the bottom of the trench (22');
   - forming (S15) a first electrode (24) comprising:

      o a first portion (24a) in Schottky contact with the first semiconductor layer (22), the first portion of the first electrode being arranged on the electrically insulating layer (26) and against a side wall of the projecting portion (22b) of the first semiconductor layer (22);
      ◦ a second portion (24b) in ohmic contact with the second semiconductor layer (23);

   - forming (S16) a second electrode (25) in ohmic contact with the substrate (21).

10. Method according to claim 9, wherein the step of etching the trench (22') has an isotropy coefficient greater than 0.3.

11. Method according to one of claims 9 and 10, wherein the step of formation of the electrically insulating layer (26) at the bottom of the trench (22') comprises the following operations:

   - forming (S13) a dielectric material layer (28) comprising a first portion (28a) arranged at the bottom of the trench and a second portion (28b) arranged against the side wall of the projecting portion (22b) of the first semiconductor layer (22), the first portion (28a) having a thickness greater than that of the second portion (28b); and
   - etching (S14) in an isotropic manner the dielectric material layer (28) in such a way as to remove only the second portion (28b).

12. Method according to any one of claims 9 to 11, wherein the step of formation of the first electrode (24) comprises the following operations:

   - depositing a layer (29a) of a first metal on the electrically insulating layer (26), against the side wall of the projecting portion (22b) of the first semiconductor layer (22) and on the second semiconductor layer (23);
   - forming in the layer (29a) of the first metal an opening (30) emerging on the second semiconductor layer (23);
   - depositing a layer (29b) of a second metal in the opening (30), in contact with the second semiconductor layer (23), the second metal being distinct from the first metal.

# Fig. 1

# Fig. 2

# Fig. 3

# Fig. 4

# Fig. 5

# Fig. 6

# Fig. 7

# Fig. 8

Fig. 9A

-S11-

Fig. 9B

-S12-

Fig. 9C

-S13-

-S14-     **Fig. 9D**

-S15-     **Fig. 9E**

-S16-     **Fig. 9F**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2018097123 A

**Littérature non-brevet citée dans la description**

- Vertical GaN junction barrier schottky diodes by Mg implantation and activation annealing. **A. D. KOEHLER et al.** 2016 IEEE 4th Workshop on Wide Bandgap Power Devices and Applications (WiPDA). IEEE, 2016, 344-346

- **W. LI et al.** Design and realization of GaN trench junction-barrier-Schottky-diodes. *IEEE Transactions on Electron Devices,* 2017, vol. 64 (4), 1635-1641